# EUROPEAN PATENT APPLICATION

(11) **EP 2 009 496 A1**
(43) Date of publication of application: **31.12.2008**
(21) Application number: 08158324.7
(22) Date of filing: 16.06.2008
(51) Int. Cl.: G03B 27/54, G03G 15/04

(54) **Optical Scanning Unit**

(30) Priority: 26.06.2007 KR 20070063137
(71) Applicant: SAMSUNG ELECTRONICS CO., LTD., Suwon-si, Gyeonggi-do (KR)
(72) Inventor: Choi, An-sik, Yeongtong-gu, Suwon-si Gyeonggi-do (KR)
(74) Representative: Walaski, Jan Filip

(57) **Abstract**

An optical scanning unit that deflects light in a main scanning direction to radiate the light on an exposure object. The optical scanning unit includes a light source having a signal terminal, and a circuit board having a slot-shaped inserting portion into which the signal terminal is inserted.

## Description

The present invention relates to an optical scanning unit and an image forming apparatus including the same, and more particularly, to an optical scanning unit that scans light radiated from a light source onto a photoconductor and an electro-photographic image forming apparatus including the optical scanning unit.

An electro-photographic image forming apparatus includes an optical scanning unit that scans light modulated in response to an image information signal onto a photoconductor (exposure object), after the light is deflected in a main scanning direction using a deflector such as a polygonal mirror. The optical scanning unit includes a collimating lens, a cylindrical lens, and an fθ lens in order to image light radiated from a light source onto an exposure object in a spot shape. To realize excellent printing quality, light having uniform intensity should be radiated entirely in the main scanning direction of the photoconductor. The collimating lens, the cylindrical lens, the fθ lens, and the like are designed on the basis of the above condition. However, the distribution of light intensity in the main scanning direction may be non-uniform because of other factors. In particular, the light intensity may become weaker at both edges in the main scanning direction.

The present invention provides an improved optical scanning unit that can be assembled easily, has reduced manufacturing costs, and radiates light with uniform intensity onto an exposure object in all main scanning directions, and an electro-photographic image forming apparatus including the optical scanning unit.

Additional aspects and utilities of the present invention will be set forth in part in the description which follows and, in part, will be obvious from the description, or may be learned by practice of the invention.

The foregoing and/or other aspects and utilities of the present invention are achieved by providing an optical scanning unit that deflects spot-shaped light in a main scanning direction to radiate the light onto an exposure object, the optical scanning unit including: a light source having a signal terminal; and a circuit board having a slot-shaped inserting portion into which the signal terminal is inserted.

The foregoing and/or other aspects and utilities of the present invention are also achieved by providing an electro-photographic image forming apparatus including: a photoconductor; an optical scanning unit that forms an electrostatic latent image by scanning light onto the photoconductor; and a developing unit to develop the electrostatic latent image by supplying toner onto the electrostatic latent image formed in the photoconductor, wherein the optical scanning unit includes a light source having a signal terminal, and a circuit board having a slot-shape inserting portion into which the signal terminal is inserted.

The light source may be a laser light source, and the signal terminal may include an LD terminal to provide oscillation driving of a laser, a PD terminal to detect light, and a common terminal.

The light source may radiate a plurality of laser lights, and the signal terminal may include a plurality of the LD terminals.

The optical scanning unit may further include a supporting member having an inserting hole into which a body of the light source is inserted, wherein the circuit board may be combined with the supporting member.

The circuit board may include a plurality of the slot-shaped insertions, and the light source including a plurality of the signal terminals that insert into a respective one of the insertion portions such that the light source is rotatable while secured to the circuit board.

The optical scanning unit may further include a supporting member including a supporting hole that supports a light emitting side of the light source therein, the supporting member connectable to the circuit board such that the light source is rotatably secured between the circuit board and the supporting member.

The plurality of slots can be formed in an arc shape to provide a predetermined amount of rotation of the light source while the plurality of terminals are inserted therein.

The optical scanning unit may further include: a first optical device to collimate light radiated from the light source; a deflector to deflect the light in a main scanning direction; a second optical device to focus the collimated light onto the deflector; and a focusing optical device to focus the light deflected by the deflector on an exposure object.

The foregoing and/or other aspects and utilities of the present invention are also achieved by providing an optical scanning unit, including a circuit board including a plurality of slots, and a light source including plural terminals that insert into a respective one of the slots such that the light source is rotatable while secured to the circuit board.

The optical scanning unit may further include a supporting member including a supporting hole that supports a light emitting side of the light source therein, the supporting member connectable to the circuit board such that the light source is rotatably secured between the circuit board and the supporting member.

The plurality of slots can be formed in an arc shape to provide a predetermined amount of rotation of the light source while the plurality of terminals are inserted therein.

The above and other features and utilities of the present invention will become more apparent by describing in detail exemplary embodiments thereof with reference to the attached drawings in which:
FIG. 1 illustrates a structure of an electro-photographic image forming apparatus according to an embodiment of the present invention;
FIG. 2 illustrates a structure of an electro-photographic image forming apparatus to perform color printing, according to an embodiment of the present invention;
FIG. 3 is a schematic perspective view illustrating an optical arrangement of an optical scanning unit used in the electro-photographic image forming apparatus of FIGS. 1 and 2, according to an embodiment of the present invention;
FIG. 4 is a schematic view illustrating a light path with respect to a sub-scanning direction of the optical scanning unit of FIG. 3, according to an embodiment of the present invention;
FIG. 5 is a schematic view illustrating a light path with respect to a main scanning direction of the optical scanning unit of FIG. 3, according to an embodiment of the present invention;
FIG. 6 is a perspective view illustrating relations between a signal terminal of a light source and an inserting portion of a circuit board, according to an embodiment of the present invention;
FIG. 7 is a perspective view explaining a coupling process between the light source and the circuit board, according to an embodiment of the present invention;
FIG. 8 is a perspective view illustrating relations between a signal terminal of a light source and an inserting portion of a circuit board when a light source radiating a plurality of lights is employed, according to an embodiment of the present invention; and
FIG. 9 is a schematic view illustrating a light path with respect to a sub-scanning direction when a light source radiating a plurality of lights is employed, according to an embodiment of the present invention.

Reference will now be made in detail to the embodiments of the present invention, examples of which are illustrated in the accompanying drawings, wherein like reference numerals refer to the like elements throughout. The embodiments are described below in order to explain the present invention by referring to the figures.

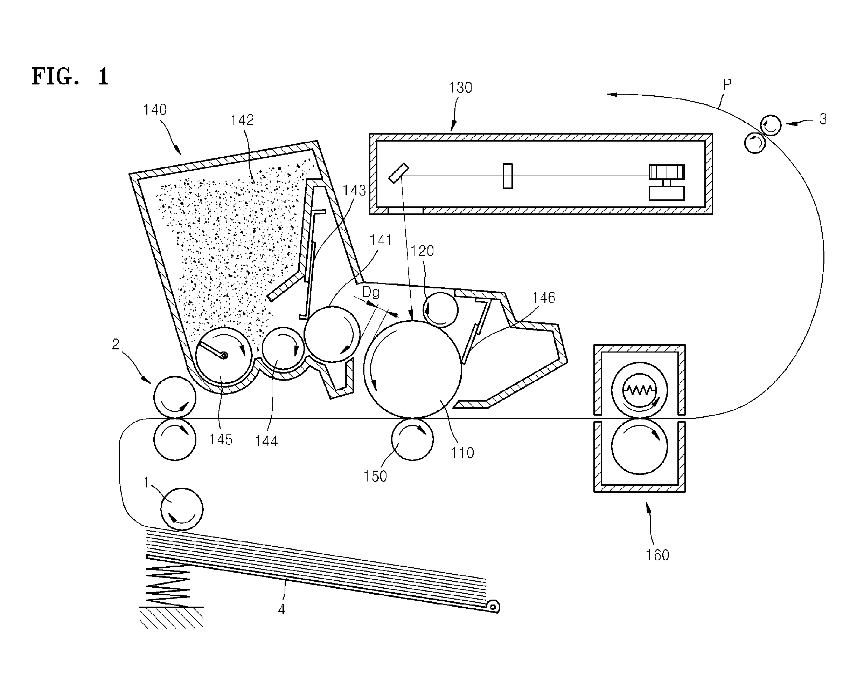

FIG. 1 shows a structure of an electro-photographic image forming apparatus according to an embodiment of the present invention. Referring to FIG. 1, the electro-photographic image forming apparatus includes a photoconductive drum 110, a charge roller 120, an optical scanning unit 130, a developing unit 140, a transfer roller 150, and a fusing unit 160.

The photoconductive drum 110 is an example of a photoconductor, and has a photoconductive layer formed on an outer surface of a cylindrical metal pipe to a predetermined thickness. Although it is not illustrated in the drawing, a belt-shaped photoconductive belt may alternatively be employed as the photoconductor. The charge roller 120 is an example of a charger, and contacts and rotates together with the photoconductive drum 110 to charge a surface thereof to a uniform potential. A charge bias voltage is applied to the charge roller 120. Also, a corona charger can be used instead of the charge roller 120. The optical scanning unit 130 forms an electrostatic latent image by scanning modulated light according to an image information signal onto the charged photoconductive drum 110 so that the charged photoconductive drum 110 has a uniform potential.

The developing unit 140 includes a developing roller 141 that faces and rotates together with the photoconductive drum 110. A developing bias voltage is applied to the developing roller 141. Toner contained in a toner container 142 is attached to a surface of the developing roller 141 and moves to a developing nip where the photoconductive drum 110 and the developing roller 141 face each other. Then, the toner is attached to an electrostatic latent image formed on the photoconductive drum 110 in response to the developing bias voltage. A control unit 143 controls the toner amount attached onto the surface of the developing roller 141. A supply roller 144 and an agitator roller 145 supply the toner contained in the toner container 142 to the developing roller 141. A supply bias voltage may be applied to the supply roller 144 in order to attach the toner to the developing roller 141. The image forming apparatus according to the current embodiment employs a noncontact developing method. The developing roller 141 is spaced apart from the photoconductive drum 110 by a developing gap Dg. The image forming apparatus can also employ a contact developing method in which the developing roller 141 contacts the photoconductive drum 110. In this case, at least the outer surface of the developing roller 141may be made of an elastic body.

The transfer roller 150 is an example of a transfer unit, and is located to face and form a transfer nip with the photoconductive drum 110. A transfer bias voltage is applied to the transfer roller 150 so that toner images formed on the photoconductive drum 110 are transferred to a recording medium P. Also, a corona transfer unit can be used instead of the transfer roller 150.

A process to form images will now be described. A charge bias voltage is applied to the charge roller 120, and the photoconductive drum 110 is charged to a uniform potential. The optical scanning unit 130 scans light modulated corresponding to an image information signal onto the photoconductive drum 110 to form an electrostatic latent image on the outer surface of the photoconductive drum 110. Toner contained in the toner container 142 is attached to the surface of the developing roller 141 by the agitator roller 145 and the supply roller 144. The control unit 143 forms a uniform toner layer on the surface of the developing roller 141. A developing bias voltage is applied to the developing roller 141. The toner attached to the developing roller 141 in response to the developing bias voltages is attached to the electrostatic latent image across the developing gap Dg. Thus, a toner image is formed on the photoconductive drum 110. The recording medium P drawn from a loading unit 4 by a pick-up roller 1 is transferred to the transfer nip where the transfer roller 150 and the photoconductive drum 110 face each other. Then, a transfer bias voltage is applied to the transfer roller 150, and the toner image is transferred to the recording medium P by an electrostatic force due to the transfer bias voltage. In the fusing unit 160, the toner image transferred to the recording medium P is fixed onto the recording medium P by heat and pressure, and accordingly, image printing is finished. Afterwards, the recording medium P exits the image forming apparatus via an exit roller 3, and waste toner, which is not transferred onto the recording medium P and remains on the surface of the photoconductive drum 110, is removed by a cleaning blade 146.

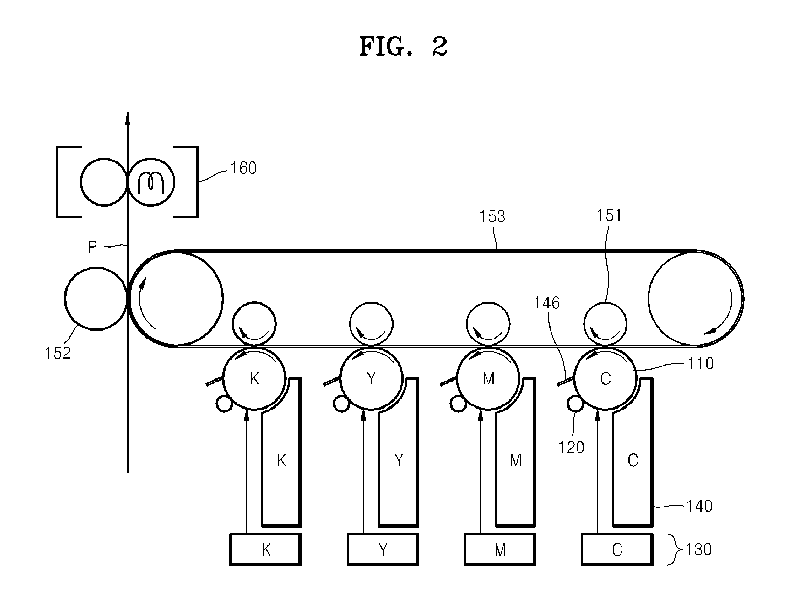

FIG. 2 illustrates a structure of an electro-photographic image forming apparatus to perform color printing, according to an embodiment of the present invention. Referring to FIG. 2, the electro-photographic image forming apparatus includes four optical scanning units 130, four photoconductive drums 110, four charge rollers 120, and four developing units 140 to develop cyan (C), magenta (M), yellow (Y), and black (K) images, respectively. A transfer belt 153 contacts the four photoconductive drums 110 and moves in conjunction with the photoconductive drums 110. Cyan (C), magenta (M), yellow (Y) and black (K) toner images developed on the photoconductive drum 110 are transferred to the transfer belt 153 in response to a first transfer bias voltage applied to a first transfer roller 151. Afterwards, the toner image is transferred from the transfer belt 153 to the recording medium P in response to a second transfer bias voltage applied to a second transfer roller 152. In the fusing unit 160, the toner image transferred to the recording medium P is then fixed onto the recording medium P by heat and pressure, and accordingly, the printing is finished.

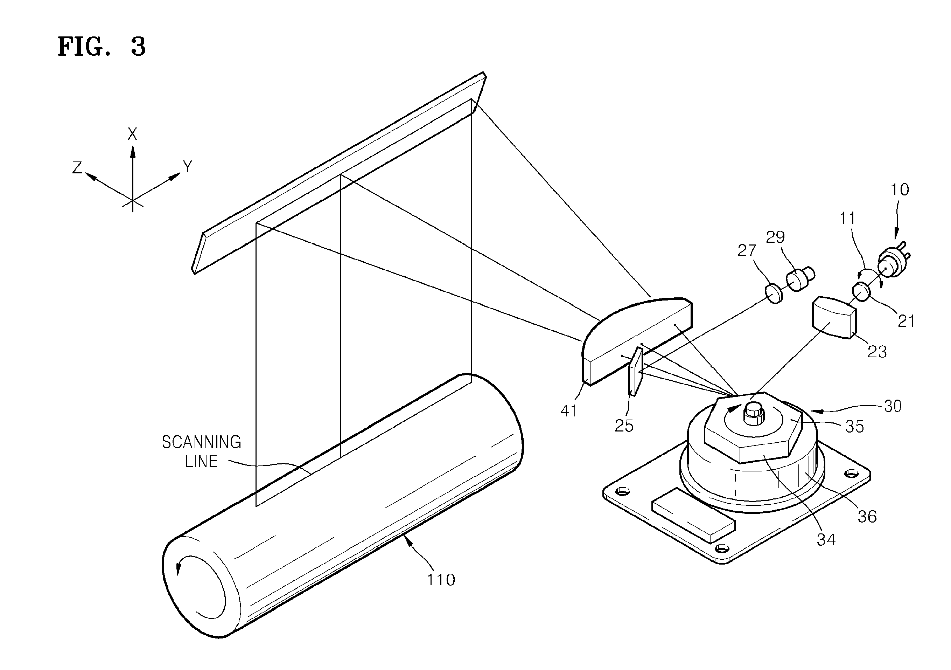

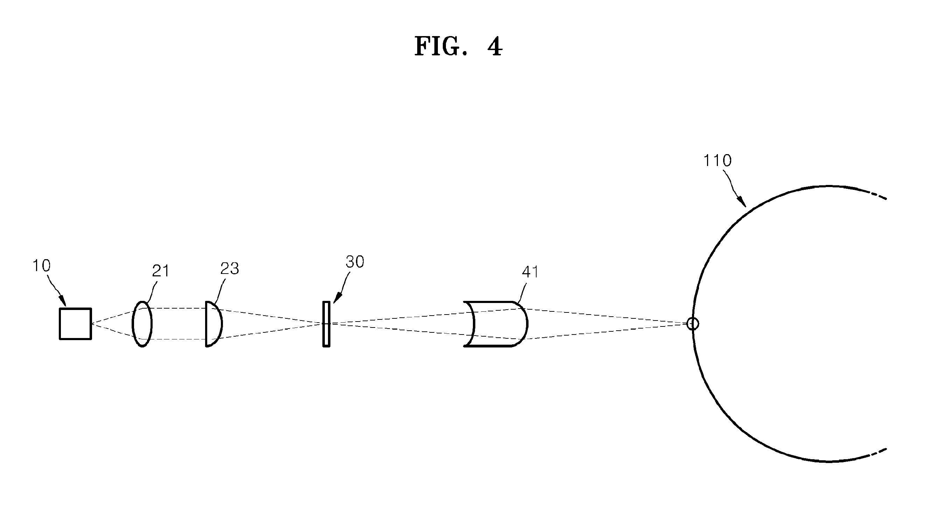

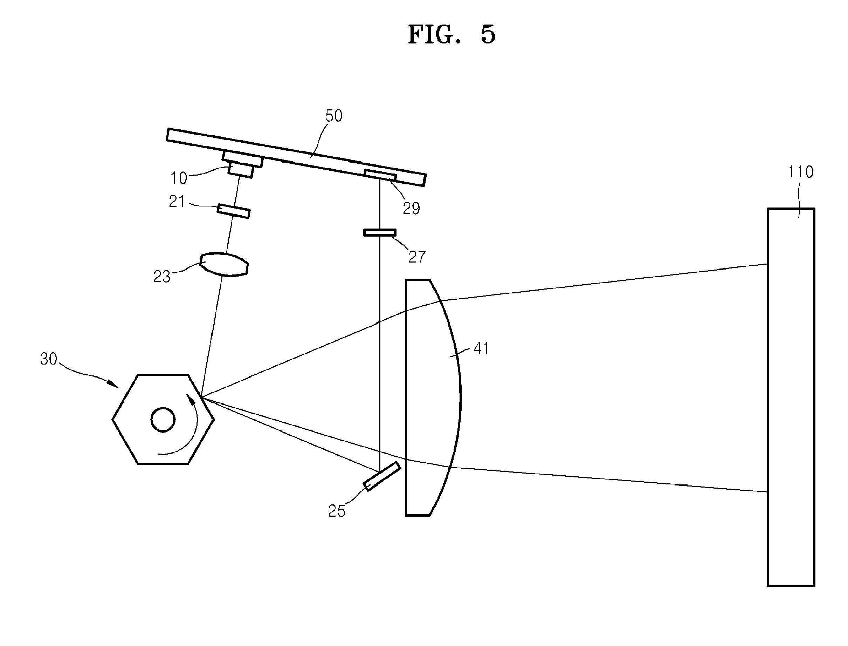

FIG. 3 is a schematic perspective view illustrating an optical arrangement of an exemplary optical scanning unit 130 used in the electro-photographic image forming apparatus of FIGS. 1 and 2, according to an embodiment of the present invention. FIG. 4 is a schematic view illustrating a light path with respect to a sub-scanning direction of the optical scanning unit 130 of FIG. 3, according to an embodiment of the present invention. FIG. 5 is a schematic view illustrating a light path with respect to a main scanning direction of the optical scanning unit 130 of FIG. 3, according to an embodiment of the present invention.

Referring to FIGS. 3 through 5, the optical scanning unit 130 includes a light source 10 radiating light, and a deflector 30 to deflect and scan light radiated from the light source 10 in a main scanning direction Y of the photoconductive drum 110. Hereinafter, the photoconductive drum 110 will be referred to as an exposure object 110. A laser diode can be employed as the light source 10. As illustrated in FIG. 3, the deflector 30 includes a polygonal mirror 35 having a plurality of reflective surfaces 34, and a motor 36 rotating the polygonal mirror 35.

A first optical device 21 and a second optical device 23 are located on the light path between the light source 10 and the deflector 30. The first optical device 21 condenses light radiated from the light source 10 to make the light parallel. The second optical device 23 condenses light that passed through the first optical device 21 in a direction corresponding to a sub-scanning direction X, so that the light can be linearly focused on the deflector 30. The second optical device 23 includes at least one cylindrical lens.

The optical scanning unit 130 further includes a focusing optical device 41. The focusing optical device 41 is interposed between the deflector 30 and the exposure object 110. For example, the focusing optical device 41 may be an fθ lens including at least one lens. The fθ lens 41 focuses light deflected by the deflector 30 on the exposure object 110 with different magnifications in the main scanning direction Y and the sub-scanning direction X. The fθ lens 41 may be formed of a plastic aspheric lens to reduce the size and the number of required components. The fθ lens 41 includes at least one non-spherical or freeform surface with a curvature varying in the sub-scanning direction X. The shape of the fθ lens 41 is not limited to that illustrated in FIG. 2. According to the above structure, light radiated from the light source 10 is deflected in the main scanning direction Y to be focused on the exposure object 110.

A reflection mirror 25 reflects part of light deflected by the deflector 30 to direct it to a synchronization signal detecting sensor 29. A condenser lens 27 condenses the light reflected by the reflection mirror 25 on the synchronization signal detecting sensor 29. The synchronization signal detecting sensor 29 generates a synchronization signal to adjust a horizontal synchronization (synchronization in the main scanning direction) of a scanning line.

To obtain an image having uniform quality, light intensity should be uniform along the entire scanning line. The first optical device 21, the second optical device 23, and the focusing optical device 41 are designed in consideration of such condition. However, under different conditions, the light intensity may not be uniform. In particular, the light intensity may decrease at both edges of the main scanning direction Y of the scanning line. In this case, changing the designs of the first optical device 21, the second optical device 23 and the focusing optical device 41 may cause problems such as delay in the production time, increase of manufacturing costs, and the like.

When the light radiated from the light source 10 and deflected by the deflector 30 passes through the focusing optical device 41, the light path and the amount of light absorption vary according to the deflection angle. Therefore, the amount of the light which reaches the exposure object 110 may not be uniform in the main scanning direction. To solve this problem, a method of rotating the light source 10 can be considered. When the light is radiated from the light source 10, light transmissivity varies according to its polarizing direction and polarizing angle. Thus, non-uniformity of the light intensity in the main scanning direction on the exposure object 110 can be improved by rotating the light source 10 in an arrow 11 direction as illustrated in FIG. 3 to change the polarizing angle of the light. The present invention provides the optical scanning unit in which an installation angle of the light source 10 varies due to rotation of the light source 10. Therefore, the details of a principle, which makes a distribution of light density uniform by rotating the light source 10, will be omitted.

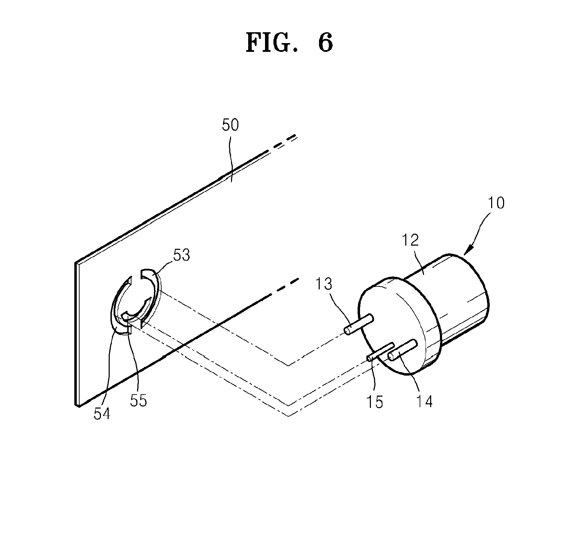

The light source 10 includes a laser diode (not shown) to generate light and a photodetector (not shown) to detect the intensity of the light generated by the laser diode. Referring to FIG. 6, signal terminals 13, 14, and 15 protrude from a body 12 of the light source 10. The signal terminal 13 is a laser diode (LD) terminal for oscillation driving of the laser diode. The signal terminal 14 is a photodetector (PD) terminal connected with the photodetector. The signal terminal 15 is a common terminal. A circuit board 50 includes terminal inserting portions 53, 54, and 55 into which the LD terminal 13, the PD terminal 14, and the common terminal 15 are respectively inserted. In an optical scanning unit 130 according to an embodiment of the present invention, when the light source 10 is rotated by a predetermined angle as represented by reference number 11 of FIG. 3, each of the inserting portions 53, 54, and 55 may have a slot form so as to receive the LD terminal 13, the PD terminal 14 and the common terminal 15, respectively. The positions of the LD terminal 13, the PD terminal 14 and the common terminal 15 change when the light source 10 is rotated. Accordingly, if the inserting portions 53, 54, and 55 each have a circular form, a new circuit board 50 has to be used in order to rotate the light source 10. However, according to the optical scanning unit 130 described in the above embodiments , by forming the inserting portions 53, 54 and 55 so as to have a slot form in the circuit board 50, even when the light source 10 rotates to make the light intensity uniform, it is not necessary to use a new circuit board 50. Therefore, additional manufacturing costs are avoided, and production time is not delayed. The inserting portions 53, 54, and 55 may have a circular arc form. However, the present invention is not limited to the above examples, and may have other shapes accordingly, which perform the intended purposes of the inventive concept as described herein.

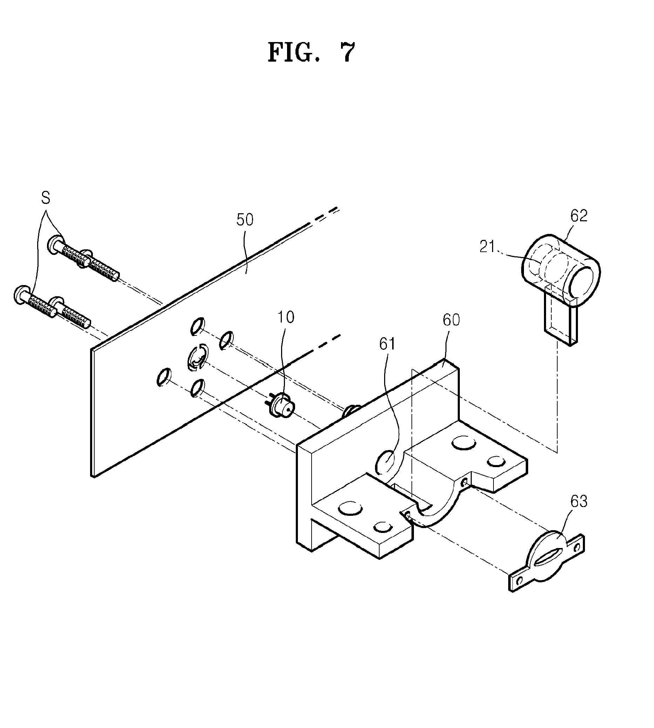

Referring to FIG. 7, an example of a process of combining the light source 10 and the circuit board 50 will now be described. The body 12 of the light source 10 is inserted into an inserting hole 61 formed in a supporting member 60. At this point, the light source 10 is inserted to be located in a proper rotation location so as to make the light intensity uniform. Then, the LD terminal 13, the PD terminal 14, and the common terminal 15 of the light source 10 are inserted into the inserting portions 53, 54, and 55 of the circuit board 50, respectively. Then, the supporting member 60 and the circuit board 50 are combined using screws S. Afterwards, the LD terminal 13, the PD terminal 14, and the common terminal 15 are respectively soldered on a rear surface of the circuit board 50. Then, the supporting member 60 is combined with a frame (not shown) of the optical scanning unit 130. At this point, a holder 62 combined with a first optical device 21 can be combined with the supporting member 60. Reference number 63 denotes an aperture.

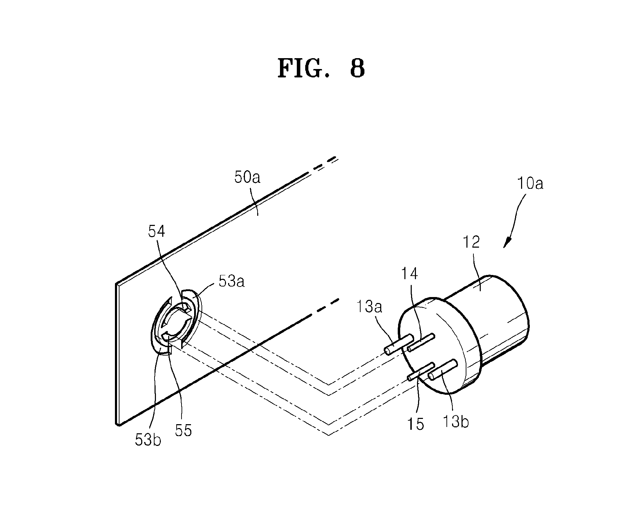

Referring to FIG. 8, a light source 10a that generates two laser lights may be employed. In this case, the light source 10a includes LD terminals 13a, 13b, the PD terminal 14, and the common terminal 15. Inserting portions 53a and 53b, into which the LD terminals 13a and 13b are inserted, and inserting portions 54 and 55, into which the PD terminal 14 and the common terminal 15 are inserted, are formed in a circuit board 50a. To correspond to the rotation of the light source 10a for making the light intensity uniform, the inserting portions 53a, 53b, 54, and 55 are formed in a slot form.

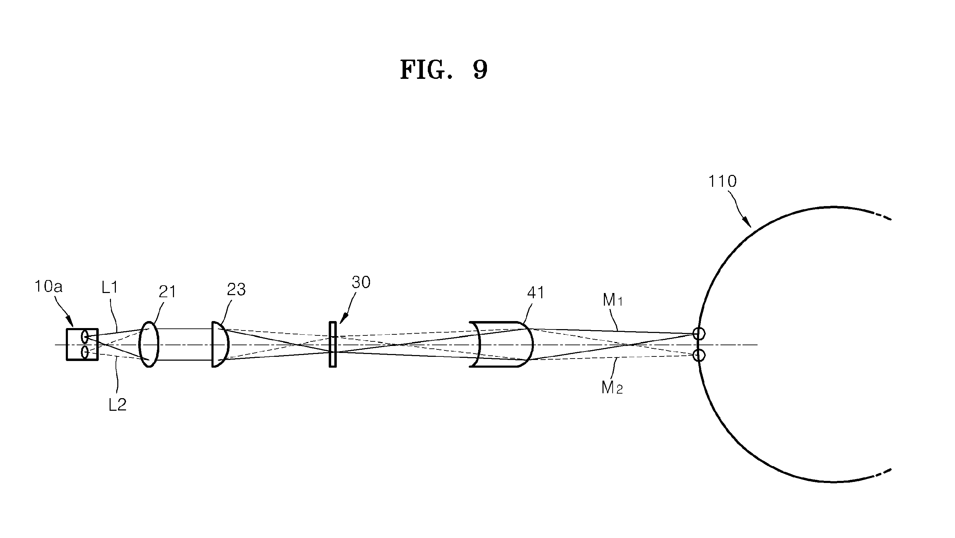

FIG. 9 is a schematic view illustrating a light path with respect to a sub-scanning direction when a light source radiating a plurality of lights is employed, according to an embodiment of the present invention. Referring to FIG. 9, two lights are simultaneously radiated on the photoconductive drum 110. The two lights L1 and L2 radiated from the light source 10a form first and second scanning lines M1, M2 spaced apart from each other in a sub-scanning direction X on the photoconductive drum 110. A distance between the first scanning line M1 and the second scanning line M2 simultaneously radiated on the photoconductive drum 110 in the sub-scanning direction X is determined by a gap between the two lights L1 and L2 and an optical amplification of an optical system. The number of the lights radiated from the light source 10a is not limited to two. As described above, by employing the light source 10a radiating a plurality of lights, a plurality of scanning lines are formed by scanning only once. Accordingly, image forming speed can be increased.

As described above, according to the various embodiments of an optical scanning unit described herein and an electro-photographic image forming apparatus including the same, the light intensity along a scanning line can be made uniform. Even when an angle of a light source is changed, it is unnecessary to manufacture a new circuit board. Therefore, manufacturing costs can be saved, and the development time can be reduced. Also, the same circuit board can be used for many models of the optical scanning unit.

Although a few embodiments of the present invention have been shown and described, it will be appreciated by those skilled in the art that changes may be made in these embodiments without departing from the principles of the invention, the scope of which is defined in the appended claims.

## Claims

1. An optical scanning unit, comprising:
a light source (10) including a signal terminal (13, 14, 15); and
a circuit board (50) having a slot (53, 54, 55) for receiving the signal terminal, such that the light source is rotatable while mounted to the circuit board.

2. The optical scanning unit of claim 1, wherein the light source is a laser light source, and the signal terminal comprises a first terminal LD for oscillation driving of a laser, a second terminal PD for light detection, and a common terminal.

3. The optical scanning unit of claim 2, wherein the light source comprises a plurality of laser light sources, and the signal terminal comprises a plurality of the first terminals.

4. The optical scanning unit of any one of the preceding claims, further comprising:
a supporting member comprising an inserting hole into which a body of the light source is received,
wherein the circuit board is combined with the supporting member.

5. The optical scanning unit of any one of the preceding claims, wherein the circuit board includes a plurality of slots and the light source includes a plurality of signal terminals that insert into respective ones of the slots, such that the light source is rotatable while mounted to the circuit board.

6. The optical scanning unit of claim 5, further comprising:
a supporting member including a supporting hole that supports a light emitting side of the light source therein, the supporting member connectable to the circuit board such that the light source is rotatably secured between the circuit board and the supporting member.

7. The optical scanning unit of claim 5 or 6, wherein the plurality of slots are formed in an arc shape to provide a predetermined amount of rotation of the light source while the plurality of terminals are inserted therein.

8. The optical scanning unit of any one of the preceding claims, further comprising:
a first optical device for collimating light radiated from the light source;
a deflector for deflecting the light in a main scanning direction;
a second optical device for focusing the collimated light on the deflector; and
a focusing optical device for focusing the light deflected by the deflector on an exposure object.

9. An electro-photographic image forming apparatus comprising:
a photoconductor;
an optical scanning unit as claimed in any one of the preceding claims for forming an electrostatic latent image by scanning light onto the photoconductor; and
a developing unit for developing the electrostatic latent image by supplying toner to the electrostatic latent image formed on the photoconductor.
